# EUROPÄISCHE PATENTSCHRIFT

(11) **EP 2 937 951 B1**
(45) Veröffentlichungstag und Bekanntmachung des Hinweises auf die Patenterteilung: **21.08.2019**
(21) Anmeldenummer: 15161841.0
(22) Anmeldetag: 31.03.2015
(51) Int. Cl.: H01B 7/08, H05K 1/02, H01R 35/02, H01R 43/28, H01R 12/65, H01R 12/77

(54) **Wickelfeder mit einem Flachbandkabel und einem Stecker**
Coil spring with a ribbon cable and a connector
Ressort d'enroulement avec un câble plat et un connecteur

(30) Priorität: 11.04.2014 DE 102014105187
(43) Veröffentlichungstag der Anmeldung: 28.10.2015
(73) Patentinhaber: Valeo Schalter und Sensoren GmbH, 74321 Bietigheim-Bissingen (DE)
(72) Erfinder: Schwarz, Viktoria, 74321 Bietigheim-Bissingen (DE); Intini, Onofrio, 74321 Bietigheim-Bissingen (DE)
(74) Vertreter: Pothmann, Karsten

(56) Entgegenhaltungen:
- EP-A2- 1 349 182
- DE-A1- 4 004 233
- DE-A1- 10 054 155
- DE-U1- 20 003 965
- GB-A- 235 072
- US-A- 4 367 585

## Beschreibung

Die Erfindung betrifft eine Wickelfeder mit einem Flachbandkabel und einem Stecker.
Flachbandkabel an sich sind aus dem Stand der Technik allgemein bekannt, beispielsweise aus der DE 198 82 022 B4, der US4367585A, der EP1349182A2, der DE10054155A1, der GB235072A, oder der DE 196 04 797 A1. Derartige Flachbandkabel werden häufig in sogenannten Wickelfedern eingesetzt, wie sie beispielsweise in Lenkeinrichtungen eines Fahrzeugs verbaut werden, um eine elektrische Verbindung zwischen einem Lenkrad als Rotor und der Lenksäule bzw. dem Fahrzeug als Stator zu ermöglichen. Wickelfedern sind beispielsweise aus der DE20003965U1 oder der DE4004233A1 bekannt.

Das Flachbandkabel ist dabei in der Regel spiralförmig in einem Wickelfedergehäuse aufgewickelt und mit einem Ende am Lenkrad bzw. am Rotor und mit dem anderen Ende am Stator bzw. dem Fahrzeug verbunden. Durch die spiralförmige Aufwicklung entsteht eine federnde, flexible und damit ausgleichende Kabelverbindung.

Für jedes zu übertragende Signal ist dabei in der Regel ein Leiter im Flachbandkabel vorgesehen. Ist eine größere Anzahl von Signalen zu übertragen ist entweder ein breiteres Flachbandkabel erforderlich, was in der Regel ein größeres Wickelfedergehäuse erfordert, oder wenigstens ein weiteres Flachbandkabel, welches jeweils über separate Stecker zu verbinden ist, die ebenfalls zusätzlichen Bauraum erfordern.

Es ist Aufgabe der Erfindung, ein verbessertes Flachbandkabel bereitzustellen, mit welchem eine größere Anzahl von Signalen übertragen werden kann, insbesondere ohne dass sich der Bauraumbedarf für das Flachbandkabel nennenswert erhöht.

Diese Aufgabe wird erfindungsgemäß durch die Merkmale des Anspruchs 1 gelöst. Durch die Anordnung der Leiter in mehreren Leiterbahnschichten übereinander und nicht nebeneinander, insbesondere durch eine Anordnung in übereinander angeordneten Leiterbahnebenen, kann die Anzahl der Leiter des Flachbandkabels und damit die Anzahl der übertragbaren Signale auf
einfache Art und Weise erhöht werden, ohne dass sich der Bauraumbedarf des Flachbandkabels nennenswert erhöht, insbesondere ohne dass das Flachbandkabel breiter wird oder dass zusätzliche Kontaktierungselemente erforderlich sind.

Dies ist insbesondere bei Flachbandkabeln für Wickelfedern vorteilhaft, denn die Höhe des Wickelfedergehäuses und damit der für das Wickelfedergehäuse erforderliche Bauraum sind maßgeblich von der Breite des darin angeordneten, spiralförmig aufgewickelten Flachbandkabels abhängig.

Erfindungsgemäß weist das Flachbandkabel wenigstens zwischen zwei Leiterbahnschichten eine Isolierschicht auf, wobei sich die Isolierschicht vorzugsweise über nahezu eine gesamte Länge des Flachbandkabels erstreckt und insbesondere eine Isolierfolie ist. Dadurch kann eine erforderliche elektrische Isolierung der Leiter sichergestellt werden.

Erfindungsgemäß sind eine oberste Leiterbahnschicht und eine unterste Leiterbahnschicht von einer Isolierschicht abgedeckt, wobei sich die Isolierschicht vorzugsweise über nahezu eine gesamte Länge des Flachbandkabels erstreckt und insbesondere eine Isolierfolie ist.

Erfindungsgemäß weisen dabei wenigstens eine oberste und eine unterste Isolierschicht und die zwischen den Leiterschichten angeordneten Isolierschichten jeweils eine fensterförmige Öffnung auf, wobei die fensterförmigen Öffnungen derart übereinander angeordnet und ausgebildet sind, dass die Leiter wenigstens zweier Leiterbahnschichten durch die Öffnungen hindurch elektrisch kontaktierbar sind, mit einem Stecker oder dergleichen. Dies ermöglicht eine einfache Kontaktierung der Leiter, insbesondere an einer beliebigen Position des Flachbandkabels. Ferner ermöglichen die Aussparungen in den Isolierschichten ein problemloses Verschweißen oder Verlöten der Leiter mit anderen elektrischen Komponenten. Bevorzugt sind die fensterförmigen Öffnungen bzw. Aussparungen dabei wenigstens in einem Endbereich des Flachbandkabels angeordnet, insbesondere in beiden Endbereichen.

In einer bevorzugten Ausgestaltung sind wenigstens zwei Leiter unterschiedlicher Leiterbahnschichten zumindest teilweise, vorzugsweise vollständig, seitlich versetzt übereinander angeordnet bzw. verlaufen seitlich versetzt übereinander. Dadurch kann
eine einfache Kontaktierung mit allen Leitern des Flachbandkabels erreicht werden. Insbesondere wenn entsprechende Aussparungen, wie beispielsweise die vorbeschriebenen fensterförmige Öffnungen, in den Isolierschichten vorgesehen sind.

Zur elektrischen Kopplung des Flachbandkabels mit anderen elektrischen Komponenten weist das Flachbandkabel einen Stecker auf, in dem die Leiter von wenigstens zwei Leiterbahnschichten zusammengeführt sind. Der Stecker ist dabei durch die fensterförmigen Öffnungen in den Isolierschichten hindurch mit den Leitern kontaktiert.

Durch die Anordnung der Leiter in mehreren Leiterschichtbahnen können mehr Leiter in ein erfindungsgemäßes Flachbandkabel integriert werden als in ein aus dem Stand der Technik bekanntes Flachbandkabel vergleichbarer Breite. Somit kann mit einem erfindungsgemäßen Flachbandkabel eine größere Anzahl von Signalen übertragen werden, ohne dass nennenswert mehr Bauraum für ein breiteres Flachbandkabel erforderlich ist.

Gegenüber der Verwendung mehrerer einzelner Flachbandkabel hat das erfindungsgemäße Flachbandkabel den Vorteil, dass die Leiterbahnschichten in einem gemeinsamen Stecker zusammengeführt werden können und nicht für jede Leiterbahnschicht ein separater Stecker erforderlich ist.

Weitere Merkmale der Erfindung ergeben sich aus den Figuren und der Figurenbeschreibung.
Die Erfindung wird nun anhand eines bevorzugten Ausführungsbeispiels sowie unter Bezugnahme auf die beigefügten Zeichnungen näher erläutert.

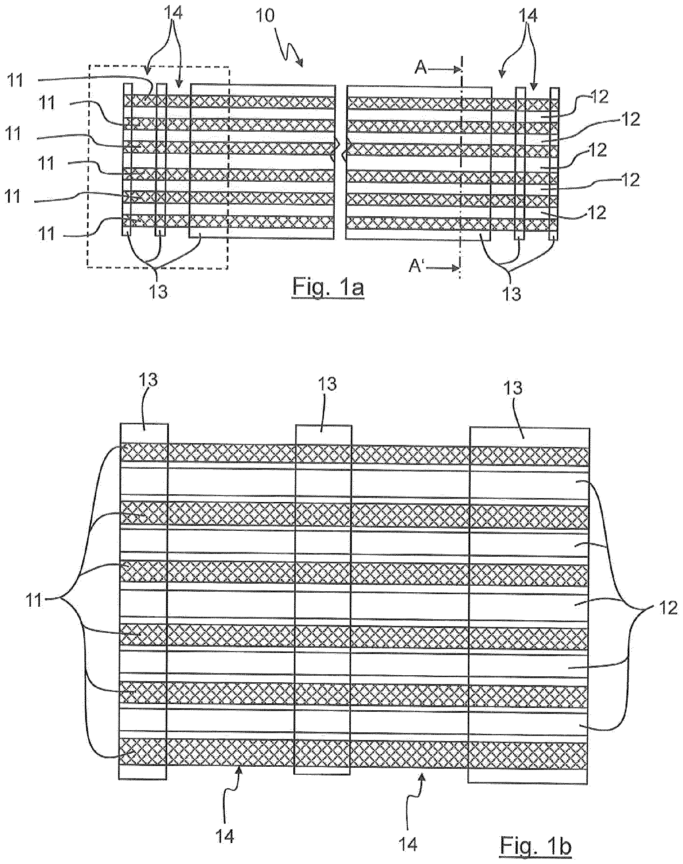

Es zeigen:Fig. 1a schematisch ein Ausführungsbeispiel eines erfindungsgemäßen Flachbandkabels in Draufsicht,
- Fig. 1b: schematisch in vergrößerter Darstellung einen Ausschnitt des in Fig. 1a gezeigten, erfindungsgemäßen Flachbandkabels und
- Fig. 2: schematisch einen Ausschnitt des erfindungsgemäßen Flachbandkabels aus den Fig. 1a und 1b in Schnittdarstellung entlang der Schnittebene A-A'.

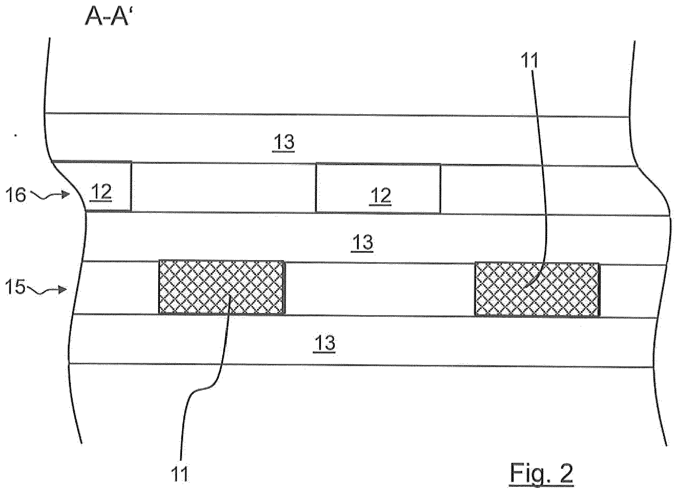

Fig. 1a zeigt in schematischer Darstellung ein erstes Ausführungsbeispiel eines erfindungsgemäßen Flachbandkabels 10 in Draufsicht. Das Flachbandkabel 10 weist mehrere parallel verlaufende Leiter 11 und 12 aus Kupfer auf, die jeweils elektrisch voneinander isoliert sind. Die Leiter 11 sind dabei in einer ersten Leiterbahnschicht bzw. Leiterbahnebene 16 angeordnet und die Leiter 12 in einer zweiten, parallel zu der ersten Leiterbahnschicht 16 verlaufenden Leiterbahnebene 15, siehe Fig. 2, die einen Schnitt entlang der Schnittebene A-A' durch das in Fig. 1a dargestellte Flachbandkabel 10 zeigt.

Bei diesem Ausführungsbeispiel sind die Leiter 11 und 12 dabei jeweils vollständig seitlich versetzt zueinander übereinander angeordnet, d.h. nicht überlappend. Zwischen den einzelnen Leiterbahnschichten 15 und 16 mit den Leitern 11 bzw. 12 ist nahezu über eine gesamte Länge des Flachbandkabels 10 eine Isolierschicht 13 aus einer Isolierfolie 13 aus Kunststoff eingebracht, um die Leiter 11 und 12 entsprechend voneinander elektrisch zu isolieren. Ferner sind die oberste Leiterbahnschicht 16 sowie die unterste Leiterbahnschicht 15 ebenfalls mit einer Isolierschicht 13 in Form einer Isolierfolie versehen.

Bei diesem Flachbandkabel weisen die Isolierschichten 13 jeweils an den Enden des Flachbandkabels 10 fensterförmige Öffnungen 14 bzw. Aussparungen auf, welche ebenfalls übereinander angeordnet sind, siehe auch Fig. 1b. Dadurch sind die Leiter 11 und 12 in diesen Bereichen jeweils freigelegt und können somit mit anderen Komponenten elektrisch kontaktiert werden, beispielsweise mit einem Stecker. Da die Isolierschichten 13 in einem Kontaktbereich ausgespart sind, kann problemlos durch Schweißen oder Löten eine elektrische Kontaktierung mit anderen Komponenten hergestellt werden.

Da alle drei Isolierschichten 13 jeweils eine entsprechende fensterförmige Öffnung 14 Bereichen aufweisen, und diese übereinander angeordnet sind, können die Leiter 11 und 12 der beiden Leiterbahnschichten 15 und 16 auch problemlos gemeinsam in einem einzigen, hier nicht dargestellten Stecker zusammengeführt und kontaktiert werden. Somit ermöglicht ein erfindungsgemäßes Flachbandkabel 10 nicht nur die Übertragung einer größeren Anzahl von Signalen, sondern mehrere Leiterbahnschichten 15, 16 können auf einfache Art und Weise in einem Stecker zusammengeführt werden. Somit kann gegenüber der Verwendung zweier herkömmlicher Flachbandkabel jeweils ein Stecker entfallen.

## Patentansprüche

1. Wickelfeder mit einem Flachbandkabel (10) und einem Stecker, wobei das Flachbandkabel (10) mehrere parallel zueinander angeordnete, von einander elektrisch isolierte Leiter (11, 12) aufweist,
wobei die Leiter (11, 12) in wenigstens zwei übereinander verlaufenden und voneinander isolierten Leiterbahnschichten (15, 16) angeordnet sind, wobei das Flachbandkabel (10) wenigstens zwischen zwei Leiterbahnschichten (15, 16) eine Isolierschicht (13) aufweist und eine oberste Leiterbahnschicht (15) und eine unterste Leiterbahnschicht (16) von einer Isolierschicht (13) abgedeckt sind, und
wobei das Flachbandkabel (10) den Stecker zur elektrischen Kopplung des Flachbandkabels (10) mit anderen elektrischen Komponenten aufweist, wobei in dem Stecker die Leiter (11, 12) von wenigstens zwei Leiterbahnschichten (15, 16) zusammengeführt sind,
**dadurch gekennzeichnet, dass** die oberste und die unterste Isolierschicht (13) jeweils eine fensterförmige Öffnung (14) aufweisen, und die zwischen den Leiterbahnschichten (15, 16) angeordnete Isolierschicht (13) eine fensterförmige Öffnung (14) aufweist, wobei die fensterförmigen Öffnungen (14) derart übereinander angeordnet und ausgebildet sind, dass die Leiter (11, 12) wenigstens zweier Leiterbahnschichten (15, 16) durch die Öffnungen (14) hindurch elektrisch kontaktierbar sind, und dass der Stecker durch die fensterförmigen Öffnungen (14) in den Isolierschichten (13) mit den Leitern (11, 12) kontaktiert ist.

2. Wickelfeder nach Anspruch 1, **dadurch gekennzeichnet, dass** das Flachbandkabel (10) wenigstens zwei Leiter (11, 12) unterschiedlicher Leiterbahnschichten (15, 16) zumindest teilweise, vorzugsweise vollständig, seitlich versetzt übereinander angeordnet verlaufen.

## Claims

1. Coil spring with a flat ribbon cable (10) and a plug, wherein the flat ribbon cable (10) has a plurality of conductors (11, 12) which are arranged parallel to one another and are electrically insulated from one another, wherein the conductors (11, 12) are arranged in at least two conductor track layers (15, 16) which run one above the other and are insulated from one another, wherein the flat ribbon cable (10) has an insulating layer (13) at least between two conductor track layers (15, 16), and a topmost conductor track layer (15) and a bottommost conductor track layer (16) are covered by an insulating layer (13), and wherein the flat ribbon cable (10) has the plug for electrically coupling the flat ribbon cable (10) to other electrical components, wherein the conductors (11, 12) of at least two conductor track layers (15, 16) are combined in the plug,
**characterized in that**
the topmost and the bottommost insulating layer (13) each have a window-like opening (14), and the insulating layer (13) which is arranged between the conductor track layers (15, 16) has a window-like opening (14), wherein the window-like openings (14) are arranged one above the other and designed in such a way that the conductors (11, 12) of at least two conductor track layers (15, 16) can be electrically contacted through the openings (14), and **in that** the plug is contacted by the conductors (11, 12) through the window-like openings (14) in the insulating layers (13).

2. Coil spring according to Claim 1, **characterized in that** the flat ribbon cable (10) at least two conductors (11, 12) of different conductor track layers (15, 16) run in a manner arranged at least partially, preferably completely, laterally offset one above the other.

## Revendications

1. Ressort d'enroulement comprenant un câble en nappe (10) et une fiche, le câble en nappe (10) possédant plusieurs conducteurs (11, 12) disposés parallèlement les uns aux autres et isolés électriquement les uns des autres,
les conducteurs (11, 12) étant arrangés en au moins deux couches de pistes conductrices (15, 16) s'étendant les unes au-dessus des autres et isolées les unes des autres, le câble en nappe (10) possédant une couche isolante (13) au moins entre deux couches de piste conductrice (15, 16), et une couche de piste conductrice supérieure (15) et une couche de piste conductrice inférieure (16) étant recouvertes par une couche isolante (13), et
le câble en nappe (10) possédant la fiche pour la connexion électrique du câble en nappe (10) avec d'autres composants électriques, les conducteurs (11, 12) d'au moins deux couches de pistes conductrices (15, 16) étant réunis dans la fiche,
**caractérisé en ce que**
les couches isolantes (13) supérieure et inférieure possédant respectivement une ouverture en forme de fenêtre (14) et la couche isolante (13) disposée entre les couches de pistes conductrices (15, 16) possède une ouverture en forme de fenêtre (14), les ouvertures en forme de fenêtre (14) étant disposées les unes au-dessus des autres et configurées de telle sorte que le contact électrique peut être établi avec les conducteurs (11, 12) d'au moins deux couches de pistes conductrices (15, 16) à travers les ouvertures (14), et **en ce que** la fiche est mise en contact avec les conducteurs (11, 12) à travers les ouvertures en forme de fenêtre (14) dans les couches isolantes (13).

2. Ressort d'enroulement selon la revendication 1, **caractérisé en ce que** le câble en nappe (10) au moins deux conducteurs (11, 12) de couches de pistes conductrices (15, 16) différentes s'étendent l'un au-dessus de l'autre en étant au moins partiellement, de préférence entièrement décalés l'un par rapport à l'autre.
